# EUROPÄISCHE PATENTSCHRIFT

(11) **EP 3 956 939 B1**
(45) Veröffentlichungstag und Bekanntmachung des Hinweises auf die Patenterteilung: **11.09.2024**
(21) Anmeldenummer: 20720897.6
(22) Anmeldetag: 16.04.2020
(51) Int. Cl.: H01M 10/42, H01M 10/48, G01R 31/367, H02J 7/00

(54) **VERFAHREN FÜR EINE KONTROLLE EINES SCHUTZVERFAHRENS FÜR DEN SCHUTZ EINER BATTERIEVORRICHTUNG**
METHOD FOR CHECKING A PROTECTION METHOD FOR PROTECTING A BATTERY DEVICE
PROCÉDÉ POUR CONTRÔLER UN PROCÉDÉ DE PROTECTION POUR PROTÉGER UN ENSEMBLE BATTERIE

(30) Priorität: 17.04.2019 AT 503512019
(43) Veröffentlichungstag der Anmeldung: 23.02.2022
(73) Patentinhaber: AVL List GmbH, 8020 Graz (AT)
(72) Erfinder: DEIML, Mathias, 93093 Donaustauf (DE); FRIZBERG, Günther, 8051 Graz (AT); GSCHWEITL, Kurt, 8063 Eggersdorf (AT); DHINGRA, Vipul, 8010 Graz (AT)
(74) Vertreter: Mathys & Squire
(86) Internationale Anmeldenummer: PCT/AT2020/060156
(87) Internationale Veröffentlichungsnummer: WO 2020/210854

(56) Entgegenhaltungen:
- WO-A1-2012/025706
- DE-T5- 112017 001 402
- DE-T5- 112017 001 482
- JP-A- 2009 128 194
- US-A1- 2011 133 744

## Beschreibung

Die vorliegende Erfindung betrifft ein Verfahren für eine Kontrolle eines Schutzverfahrens für den Schutz einer Batterievorrichtung, insbesondere einer Elektrode der Batterievorrichtung sowie eine Kontrollvorrichtung für die Durchführung eines solchen Verfahrens und ein entsprechendes Computerprogrammprodukt. Vergleichbare Verfahren sind aus JP 2009 128194 A, WO 2012/025706 A1, DE 11 2017 00142 T5 und aus US 2011/133744 A1 bekannt.

Es ist bekannt, dass Batterievorrichtungen geschützt werden sollen, um den Alterungsprozess einer solchen Batterievorrichtung zu reduzieren. Bei bekannten Batterievorrichtungen liegen Alterungsprozesse vor, welche die Batterie hinsichtlich ihrer Leistungsfähigkeit altern lassen. Diese Alterungsprozesse beruhen auf chemischen und physikalischen Grundsätzen. Eine Problematik hinsichtlich der Alterung von Batterievorrichtungen basiert auf dem Aufbau von Schichten auf der jeweiligen Elektrode der Batterievorrichtung. Beim Betrieb der Batterievorrichtung, also beim Laden und Entladen bzw. beim Einspeichern und Ausspeichern elektrischer Energie finden Übergänge von Elektronen bzw. Ionen an der jeweiligen Elektrode statt. Bei diesen Übergängen kann es vorkommen, dass der Übergang nur teilweise erfolgreich ist und sich auf diese Weise an einer Elektrode Material ablagert. Summiert sich diese Materialablagerung auf, entsteht eine Schicht auf der Elektrode, welche isolierend für den Übergang von Elektronen bzw. Ionen wirkt. Je großflächiger diese Schicht angeordnet ist bzw. je dicker diese Schicht sich ausbildet, umso schlechter ist die Leistungsfähigkeit der Batterievorrichtung und dementsprechend umso niedriger sein Gesundheitszustand bzw. sein Alterungszustand. Bekannte Lösungen, um die Alterung von Batterievorrichtungen zu begrenzen, zielen darauf ab, die Temperatur der Batterievorrichtung aktiv zu beeinflussen. Da die Temperatur eine Einwirkung auf die chemischen und physikalischen Prozesse des Alterungszustandes der Batterie einnimmt, kann durch die bekannten Lösungen die Temperierung eine Möglichkeit zur Verfügung stellen, die Batterievorrichtung vor zu schnellem Altern zu schützen. Nachteilhaft bei der Verwendung der Temperierung ist es jedoch, dass diese die Nutzbarkeit der Batterievorrichtung, insbesondere während der Ausübung der Temperierfunktion, reduziert. Darüber hinaus ist für die Temperierung selbst ein relativ hoher Energiebedarf notwendig, um zum Beispiel eine kalte Batterievorrichtung aufzuheizen oder eine zu warme Batterievorrichtung abzukühlen.

Es ist daher Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise ein Schutzverfahren für den Schutz einer Batterievorrichtung, insbesondere einer Elektrode einer Batterievorrichtung zu kontrollieren. Erfindungsgemäß wird dies durch ein Verfahren für eine Kontrolle eines Schutzverfahrens für den Schutz einer Batterievorrichtung, insbesondere einer Elektrode der Batterievorrichtung zur Verfügung gestellt. Ein solches Verfahren weist die folgenden Schritte auf:
- Überwachung wenigstens eines elektrischen Batterieparameters der Batterievorrichtung,
- Überwachung wenigstens eines Batterieparameters eines Betriebsstroms der Batterievorrichtung,
- Überwachung wenigstens eines Störparameters eines Störstroms der Batterievorrichtung,
- Vergleich des überwachten Störparameters, des überwachten Betriebsparameters und/oder des überwachten Batterieparameters mit wenigstens einem Vergleichsparameter auf Basis des Batterieparameters und/oder des Betriebsparameters,
wobei das Ergebnis des Vergleichs für eine, insbesondere nachfolgende, Erzeugung des Störparameters verwendet wird.

Die voranstehende Aufgabe wird gelöst durch ein Verfahren mit den Merkmalen des Anspruchs 1, eine Kontrollvorrichtung mit den Merkmalen des Anspruchs 11 und ein Computerprogrammprodukt mit den Merkmalen des Anspruchs 13. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Kontrollvorrichtung sowie dem erfindungsgemäßen Computerprogrammprodukt und jeweils umgekehrt, sodass bezüglich der Offenbarung zu den einzelnen Erfindungsaspekten stets wechselseitig Bezug genommen wird bzw. werden kann.

Ein erfindungsgemäßes Verfahren basiert darauf, dass ein Schutzverfahren für den Schutz der Batterievorrichtung, insbesondere der Elektrode oder einer anderen Komponente der Batterievorrichtung stattfindet. Ein solches Schutzverfahren ist insbesondere ein Schutzverfahren, welches einen Störstrom verwendet. Unter einem Störstrom ist im Sinne der vorliegenden Erfindung ein Strom zu verstehen, welcher separat vom Betriebsstrom der Batterievorrichtung auf dieselbe aufgebracht wird. So wird beispielsweise in einem Ladezustand der Batterievorrichtung ein Betriebsstrom durch den Ladestrom zur Verfügung gestellt. Entsprechende Betriebsparameter eines solchen Betriebsstroms sind die Stromfrequenz und die Stromamplitude eines solchen Ladestroms. Der elektrische Batterieparameter ist in einem solchen Fall zum Beispiel der grundsätzliche Ladezustand der Batterievorrichtung, oder aber direkt der Alterungszustand, auch State of Health (SOH) genannt. Weitere elektrische Batterieparameter können auch durch den State of Charge, also den Beladungszustand (SOC) der Batterievorrichtung zur Verfügung gestellt sein.

Bei einem Schutzverfahren im Sinne der vorliegenden Erfindung wird dieser Betriebsstrom nun mit einem Störstrom überlagert, welcher wenigstens einen definierten Störparameter aufweist. Erfindungsgemäß ist der Störstrom dabei vorzugsweise unterschiedlich vom Betriebsstrom, insbesondere hinsichtlich wenigstens eines Stromparameter. Ein solcher Stromparameter bildet dabei vorzugsweise den jeweiligen Störparameter aus. Insbesondere sind solche Störparameter ebenfalls die Stromamplitude und/oder die Stromfrequenz des Störstroms.

Erfindungsgemäß ist es dabei unerheblich, ob der Störstrom aktiv und in gezielter Weise aufgebracht wird, oder aber als vorhandener Störstrom im Stromkreis der Batterievorrichtung erkannt und damit erfindungsgemäß bewusst geduldet wird. Bevorzugt ist es jedoch, wenn ein aktives Schutzverfahren eingesetzt wird, welches auf Basis des Batterieparameters und des Betriebsparameters eines Batteriestroms entsprechende Störparameter ermittelt und Störströme erzeugt sowie auf den Betriebsstrom beaufschlagt.

Erfindungsgemäß wird nun ein solches Schutzverfahren nicht nur in kontrollierter Weise durchgeführt, sondern zusätzlich noch durch ein erfindungsgemäßes Verfahren überwacht. Diese Überwachung erfolgt durch einen Vergleich mit wenigstens einem Vergleichsparameter. Bevorzugt basiert dabei der Vergleichsparameter direkt oder indirekt auf dem Batterieparameter und/oder dem Betriebsparameter. So ist es denkbar, dass der Vergleichsparameter durch den Betriebsparameter oder den Batterieparameter direkt ausgebildet ist. Jedoch kann der Vergleichsparameter auch in indirekter Weise den Batterieparameter und/oder den Betriebsparameter widerspiegeln oder sogar eine Kombination derselben zusammen ausbilden.

Erfindungsgemäß bietet also der letzte Schritt des Verfahrens nun eine Rückkopplung an, welche es erlaubt, in kontrollierter Weise das Schutzverfahren für den Schutz einer Elektrode zu überwachen. In erster Linie dient dies dazu, den überwachten Störparameter, den überwachten Betriebsparameter oder den überwachten Batterieparameter hinsichtlich Quantität oder Qualität mit dem Vergleichsparameter zu vergleichen und damit zu überwachen. Im einfachsten Fall dient dies einer direkten Kontrolle und somit einer Qualitätssicherung des Schutzverfahrens. So kann auf diese Weise qualitativ grundsätzlich überwacht werden, dass die Schutzfunktion in der richtigen Richtung sowie mit der richtig ausgebildeten Störstromqualität und -quantität zur Verfügung gestellt wird. Jedoch ist zusätzlich auch eine quantitative Überwachung möglich, sodass die Quantität der Schutzwirkung nicht nur überwachbar, sondern, wie dies später noch erläutert wird, auch für folgende Störströme rückkoppelbar verbesserbar ist.

Mit anderen Worten lässt sich nun ein Störverfahren in direkter oder indirekter Weise überwachen und über die Nutzungsdauer der Batterievorrichtung verbessert aufprägen oder sogar in verbesserter Weise für eine erhöhte Betriebszeit der Batterievorrichtung einsetzen.

Vorteilhaft ist es, wenn bei einem erfindungsgemäßen Verfahren der Vergleich auf Basis eines Simulationsmodells der Batterievorrichtung durchgeführt wird, welches wenigstens insbesondere einen der folgenden Parameter berücksichtigt:
- Alterungszustand der Batterievorrichtung
- Ladezustand der Batterievorrichtung
- Temperatur der Batterievorrichtung
- Qualität und/oder Quantität des Störparameters
- Qualität und/oder Quantität des Betriebsparameters
- Qualität und/oder Quantität des Batterieparameters

Bei der voranstehenden Aufzählung handelt es sich um eine nicht abschließende Liste. Die einzelnen Daten können dabei zum Beispiel von einem Prüfstand zur Verfügung gestellt werden, und somit einmalig in das entsprechende Simulationsmodell eingespielt werden. Jedoch ist es auch denkbar, dass das Simulationsmodell über eine rein numerische Wiedergabe von Daten hinausgehend eine sogenannte künstliche Intelligenz bzw. ein neuronales Netzwerk aufweist. Auf diese Weise kann die Verwendung sowohl in einem Fahrzeug als auch bei anderen stationären Einsätzen der Batterievorrichtung zur Verfügung gestellt werden.

Vorteilhaft ist es darüber hinaus, wenn bei einem erfindungsgemäßen Verfahren ein Vergleich eines Batterieparameters und/oder eines Betriebsparameters mit einem Vergleichsparameter durchgeführt wird, nachdem eine Beaufschlagung mit einem Störstrom beendet ist. Während grundsätzlich ein erfindungsgemäßes Verfahren selbstverständlich kontinuierlich, semikontinuierlich oder schrittweise regelmäßig durchgeführt werden kann, ist ein entscheidender Vorteil dann erreichbar, wenn insbesondere nach der Beaufschlagung eines Störstroms das Ergebnis dieses Störstroms durch den Vergleichsparameter bewertbar wird. Der Vergleichsparameter bezieht sich dabei vorzugsweise auf eine Situation vor der Beaufschlagung oder auf eine Situation ohne Beaufschlagung mit dem Störstrom. Mit anderen Worten wird nun der Batterieparameter, insbesondere zum Beispiel der Alterungszustand der Batterievorrichtung, oder der Betriebsparameter, zum Beispiel der Betriebsstrom der Batterievorrichtung, nun nach der Beaufschlagung mit dem Störstrom kontrolliert und mit einem Vergleichsparameter für den Betriebsparameter bzw. den Batterieparameter verglichen. Beispielsweise ist es so nun denkbar, dass als Batterieparameter nach der Beaufschlagung des Störstroms der Alterungszustand mit einem entsprechenden Vergleichsparameter verglichen wird. In einem solchen Fall gibt der Vergleichsparameter ebenfalls den Alterungszustand wieder, sodass eine Differenz zwischen dem Alterungszustand gemäß dem Vergleichsparameter und dem bestimmten Alterungszustand gemäß dem Batterieparameter nach der Beaufschlagung mit dem Störstrom ermittelbar ist. Diese Differenz kann nun eine Aussage treffen, ob und in welcher qualitativen Weise der Störstrom die gewünschte Wirkung erzielt hat.

Bei einem Verfahren gemäß dem voranstehenden Absatz ist es möglich, dass der Vergleichsparameter einen Batterieparameter und/oder einen Betriebsparameter vor und/oder während der Beaufschlagung mit dem Störstrom aufweist. Somit wird der im voranstehenden Absatz erläuterte Vergleich noch spezifischer möglich. In idealer Weise kann also zum Beispiel der Batterieparameter nach der Beaufschlagung mit dem Störstrom den Alterungszustand nach dem Störstrom aufweisen und nun verglichen werden mit einem Vergleichsparameter in Form eines Alterungszustandes vor Beaufschlagung mit dem Störstrom. Somit kann die Alterung und damit die Differenz dieser beiden Alterungszustände vor dem Störstrom und nach dem Störstrom miteinander verglichen werden. Dies erlaubt es, das Absinken der Leistungsfähigkeit der Batterievorrichtung über den Verlauf bei Beaufschlagung mit dem Störstrom zu ermitteln. Insbesondere bildet dies einen Hinweis dahingehend aus, wie langsam oder wie schnell die Alterung während der Beaufschlagung mit dem Störstrom geschieht. Neben einem reinen Vergleich vor und nach der Beaufschlagung mit dem Störstrom ist dies selbstverständlich auch während der Beaufschlagung mit dem Störstrom denkbar, sodass die Kontrolle nicht nur abschließend nach einem Schutzmechanismus, sondern auch während der Durchführung eines solchen Schutzmechanismus eine Kontrollfunktion bietet.

Ebenfalls vorteilhaft kann es sein, wenn bei einem Verfahren gemäß dem voranstehenden Absatz das Ergebnis des Vergleichs für eine folgende Beaufschlagung mit einem Störstrom berücksichtigt wird. Wird nun also eine Auswertung möglich, welche eine Beaufschlagung mit einem Störstrom bei einer Batterievorrichtung hinsichtlich ihrer Qualität mit sich bringt, so kann diese Erfolgsauswertung eingesetzt werden, um bei einer folgenden Beaufschlagung nun in geänderter Weise einen Störstrom zu erzeugen bzw. zuzulassen. Mit anderen Worten kann nicht nur eine erfindungsgemäße Qualitätsüberwachung zur Verfügung gestellt werden, sondern darüber hinaus auch noch eine Rückkopplung die Qualität über den Verlauf des erfindungsgemäßen Schutzverfahrens verbessern. Diese Rückkopplung kann sowohl innerhalb einer einzelnen Batterievorrichtung, aber auch über eine Vielzahl von Batterievorrichtungen hinweg geschehen. So kann diese Erfolgsauswertung zum Beispiel in eine übergeordnete Datencloud zurückgespiegelt und zurückgespeichert werden, um von dort anderen Batterievorrichtungen an anderen Einsatzorten die entsprechende Rückkopplung zur Verfügung zu stellen. Selbstverständlich ist es auch möglich, eine Rückkopplung in das bereits erläuterte Simulationsmodell der Batterievorrichtung durchzuführen, um im laufenden Betrieb eines erfindungsgemäßen Verfahrens die Qualität des Simulationsmodells zusätzlich zu verbessern.

Vorteilhaft ist es weiter, wenn bei einem erfindungsgemäßen Verfahren als Batterieparameter ein Alterungszustand der Batterievorrichtung nach dem Störstrom mit einem Vergleichsparameter in Form eines Alterungsparameters der Batterievorrichtung vor dem Störstrom und/oder während des Störstroms eingesetzt wird. Es werden also explizit Alterungszustände miteinander vergleichbar, sodass die Alterungsgeschwindigkeit über den Verlauf des Störstroms erkennbar wird. Insbesondere kann auf diese Weise eine reduzierte Alterung nachgewiesen, und damit eine Erfolgskontrolle des Störstroms durchgeführt werden. Wie bereits mehrfach erläutert worden ist, kann sowohl eine Rückkopplung mit zukünftig aufgebrachten Störströmen als auch eine Rückkopplung mit einem Alterungsmodell in Form eines Simulationsmodels der Batterievorrichtung folgen.

Weiter von Vorteil ist es, wenn bei einem erfindungsgemäßen Verfahren beim Vergleich dieser Alterungszustände ein Alterungsgradient bestimmt wird. Es kann also die Steigung der Alterungszustände bzw. der Abnahme des Alterungszustandes bestimmt werden, sodass die Geschwindigkeit der Alterung als Qualitätsmerkmal für den Erfolg des Störstroms eingesetzt werden kann. Dies erlaubt es, die Qualität in einem möglichst kompakten und einzigen Vergleichsparameter bzw. Erfolgsparameter einzubinden und für weitere Auswertungen zur Verfügung zu stellen.

Bei dem erfindungsgemäßen Verfahren wird das Ergebnis des Vergleichs für eine insbesondere nachfolgende Erzeugung des Störparameters verwendet. Eine solche Rückkopplung ist nun eine Rückkopplung in die Störkontrolle, welche es erlaubt, bei aktiver Erzeugung des Störparameters und aktiver Erzeugung des Störstroms diesen für zukünftige Störstromsituationen an die Erkenntnisse aus der vergangenen Störstromsituation anzupassen. Diese Rückkopplung erlaubt also nicht nur eine Regelung innerhalb des Störstroms selbst, sondern sozusagen ein kontinuierliches selbstlernendes System für die zukünftige Beaufschlagung mit dem Schutzverfahren für die Elektrode.

Vorteile bringt es darüber hinaus mit sich, wenn bei einem erfindungsgemäßen Verfahren für den Vergleich ein Vergleichsparameter von wenigstens einer externen Batterievorrichtung eingesetzt wird. Wie bereits erläutert worden ist, kann es möglich sein, die Ergebnisse der Vergleiche zurückzuspeichern in eine Cloud und damit anderen Batterievorrichtungen zur Verfügung zu stellen. Werden die Batterievorrichtungen zum Beispiel stationär an unterschiedlichsten geografischen Einsatzsituationen eingesetzt oder befinden sie sich mobil in unterschiedlichen Fahrzeugen, so kann auf diese Weise ein erfindungsgemäßes Verfahren eine Kommunikation der Kontrollvorrichtungen zwischen diesen Batterievorrichtungen zur Verfügung stellen. Dabei müssen jedoch nicht mehr komplette Kontrolldaten zwischen den Batterievorrichtungen ausgetauscht werden, sondern vielmehr nur noch die Ergebnisse des Vergleichs oder die Vergleichsparameter selbst. Alterungszustände, Erfolgsergebnisse einzelner Störströme, aber auch die Verwendung von Störparametern und spezifischen Störströmen kann auf diese Weise einfach, kostengünstig und vor allem mit sehr geringem Datenaufwand zwischen unterschiedlichen Batterievorrichtungen ausgetauscht werden.

Ebenfalls von Vorteil kann es sein, wenn bei einem erfindungsgemäßen Verfahren als Vergleichsparameter ein Batterieparameter und/oder ein Betriebsparameter ohne Beaufschlagung mit einem Störstrom verwendet wird. Eine solche Information erhält man zum Beispiel aus einem entsprechenden Simulationsmodell oder durch den Vergleich mit einer Batterievorrichtung, welche auf einem parallelen Prüfstand läuft. Auch ein Prüfstandsmodell, welches als Simulationsmodell einer späteren Nutzung der Batterievorrichtung zugrunde gelegt werden kann, ist hier grundsätzlich denkbar. Mit anderen Worten kann also nun die reale Situation bei Beaufschlagung mit dem Störstrom, während der Störstrombeaufschlagung und/oder nach der Störstrombeaufschlagung, mit einer Situation ohne einen solchen Störstrom verglichen werden. Somit wird es möglich, zumindest imaginär mit einer nicht geschützten Batterievorrichtung einen Vergleich durchzuführen, und auf diese Weise zumindest imaginär die verlängerte Alterungssituation bzw. die verlängerte Nutzungssituation der Batterievorrichtung nachzuweisen und zu protokollieren.

Weitere Vorteile kann es mit sich bringen, wenn bei einem erfindungsgemäßen Verfahren für den Vergleichsparameter ein Simulationsmodell der Batterievorrichtung verwendet wird. Ein solches Simulationsmodell kann ebenfalls aus einer Simulation im Fahrzeug, aus einer Simulation in der Batterievorrichtung, aber auch aus einer Simulation an einem Prüfstand zur Verfügung gestellt sein. In einem solchen Fall sind nun keine realen Vergleichswerte mehr notwendig, sodass der entsprechende Ermittlungsaufwand, insbesondere die Notwendigkeit von Sensorvorrichtungen reduziert werden kann. Wie bereits mehrfach erläutert worden ist, kann ein solches Simulationsmodell durch die entsprechende Rückkopplung bei Erfolgskontrolle lernfähig ausgebildet werden, sodass es sich über die Nutzungsdauer eines erfindungsgemäßen Verfahrens verbessert und damit auch das Gesamtverfahren hinsichtlich seiner Erfindungsqualität optimiert wird.

Ebenfalls Gegenstand der vorliegenden Erfindung ist eine Kontrollvorrichtung für die Kontrolle einer Batterievorrichtung. Eine solche Kontrollvorrichtung weist ein Überwachungsmodul für eine Überwachung wenigstens eines elektrischen Batterieparameters einer Batterievorrichtung, ein Überwachen wenigstens eines Betriebsparameters eines Betriebsstroms der Batterievorrichtung und ein Überwachen wenigstens eines Störparameters eines Störstroms der Batterievorrichtung auf. Weiter ist ein Vergleichsmodul vorgesehen für einen Vergleich des überwachten Störparameters, des überwachten Betriebsparameters und/oder des überwachten Batterieparameters mit wenigstens einem Vergleichsparameter auf Basis des Batterieparameters und/oder auf Basis des Betriebsparameters. Das Überwachungsmodul und/oder das Vergleichsmodul sind dabei vorzugsweise für die Durchführung eines erfindungsgemäßen Verfahrens ausgebildet. Damit bringt eine erfindungsgemäße Kontrollvorrichtung die gleichen Vorteile mit sich, wie sie ausführlich mit Bezug auf ein erfindungsgemäßes Verfahren erläutert worden sind.

Ebenfalls Gegenstand der vorliegenden Erfindung ist ein Computerprogrammprodukt, umfassend Befehle, die bei der Ausführung des Programms durch einen Computer diesen veranlassen, das Verfahren gemäß der vorliegenden Erfindung durchzuführen. Damit bringt auch ein erfindungsgemäßes Computerprogrammprodukt die gleichen Vorteile mit sich, wie sie ausführlich mit Bezug auf ein erfindungsgemäßes Verfahren erläutert worden sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Figur 1: eine Ausführungsform einer erfindungsgemäßen Kontrollvorrichtung
- Figur 2: eine Situation bei einem Betriebsstrom,
- Figur 3: eine Situation bei einem Störstrom,
- Figur 4: eine Ausführungsform einer erfindungsgemäßen Kontrollvorrichtung,
- Figur 5: ein Alterungszustand beim Verlauf ohne Störstrom,
- Figur 6: ein Alterungszustand mit einem ersten Störstrom und
- Figur 7: ein Alterungszustand mit zwei Störströmen.

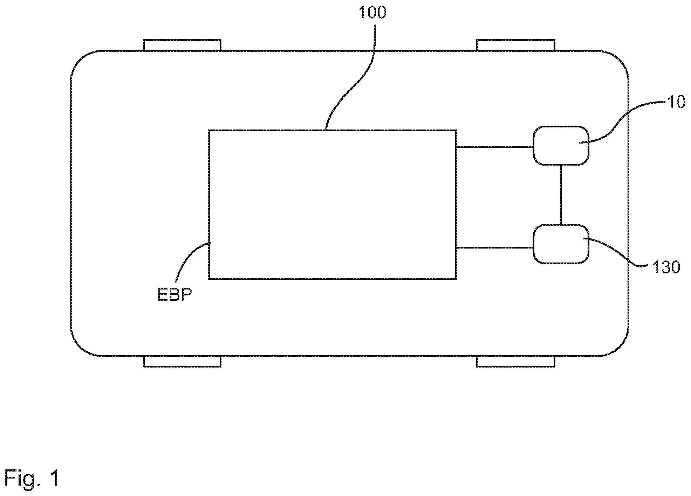

In Figur 1 ist schematisch eine mobile Batterievorrichtung 100 in einem Fahrzeug dargestellt. Diese ist hier mit einer Kontrollvorrichtung 10 versehen, auf welcher ein erfindungsgemäßes Verfahren läuft. Auf Basis zum Beispiel des elektrischen Batterieparameters EBP und eines entsprechenden Betriebsparameters BP ist es nun möglich, einen Störstrom IS zu erzeugen, welcher über einen Betriebsstrom IB übergelegt wird. Dieser Störstrom IS kann zum Beispiel durch ein Sekundärbauteil 130, zum Beispiel in Form eines Inverters der Batterievorrichtung 100 im Stromkreis derselben erzeugt werden.

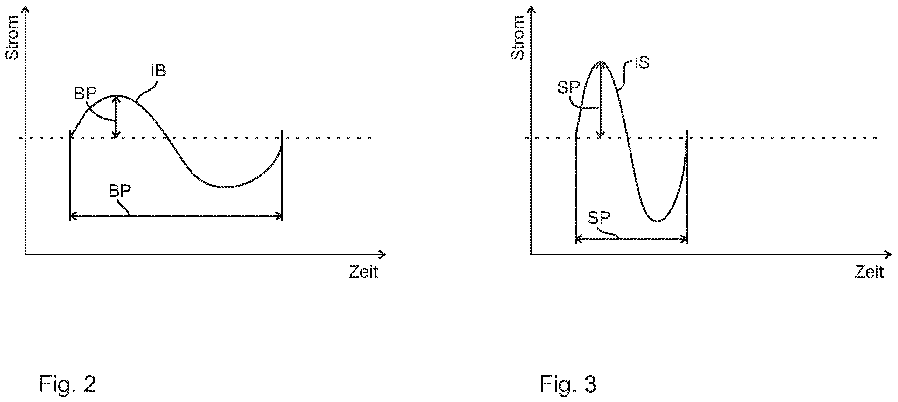

Anhand der Figuren 2 und 3 wird kurz die Funktionsweise eines solchen Störstroms IS erläutert. Ein normaler Betriebsstrom IB ist zum Beispiel gemäß Figur 2 dargestellt. Mit einer definierten Frequenz und einer definierten Amplitude sind hier zwei Betriebsparameter BP des Betriebsstroms IB angegeben. Auf dieser Basis kann nun gemäß der Figur 3 ein Störstrom IS ermittelt werden, wobei hier als Störparameter SP eine vergrößerte Amplitude und eine verkürzte Frequenz im Vergleich zum Betriebsstrom IB erzeugt worden sind. Die Erzeugung des Störstroms IS kann, wie mit Bezug auf Figur 1 erläutert worden ist, zum Beispiel durch ein Sekundärbauteil 130 erzeugt werden. Dieser Störstrom IS, welcher auch als Rippelstrom bezeichnet werden kann, wird nun auf den Betriebsstrom IB beaufschlagt und überlagert diesen sozusagen. Auf diese Weise wird es möglich, in chemischer und/oder physikalischer Weise die jeweilige Elektrode der Batterievorrichtung 100 zu schützen, da ein disharmonischer Übergang an der jeweiligen Elektrode den Aufbau einer Schicht auf der jeweiligen Elektrode behindert oder sogar gänzlich vermeidet. Solange der Störstrom IS den Betriebsstrom IB überlagert, ist dieser Effekt gegeben.

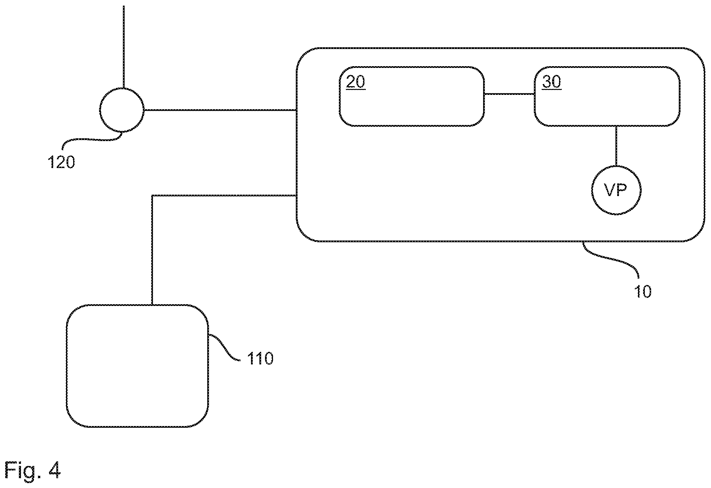

In Figur 4 ist nun schematisch eine Kontrollvorrichtung 10 der vorliegenden Erfindung dargestellt, welche es erlaubt, die Kontrolle mithilfe eines Überwachungsmoduls 20 und eines Vergleichsmoduls 30 durchzuführen. Als Eingabe von Daten können zum Beispiel eine Sensorvorrichtung 120, aber auch ein Simulationsmodell 110 dienen.

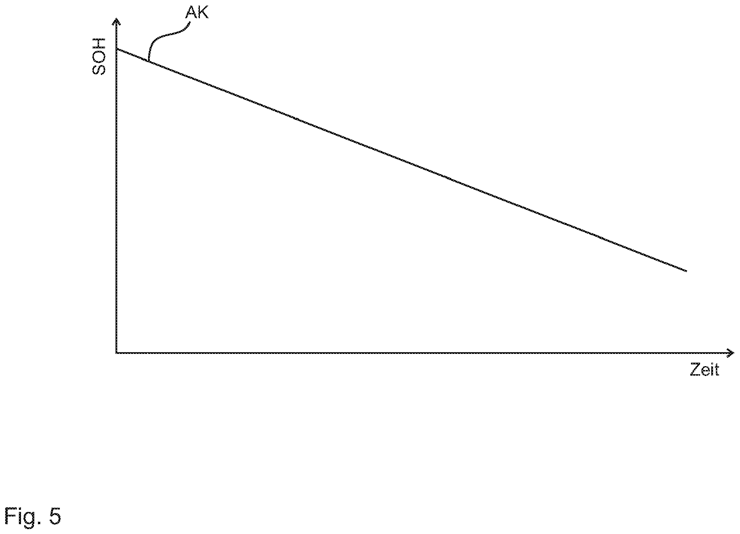

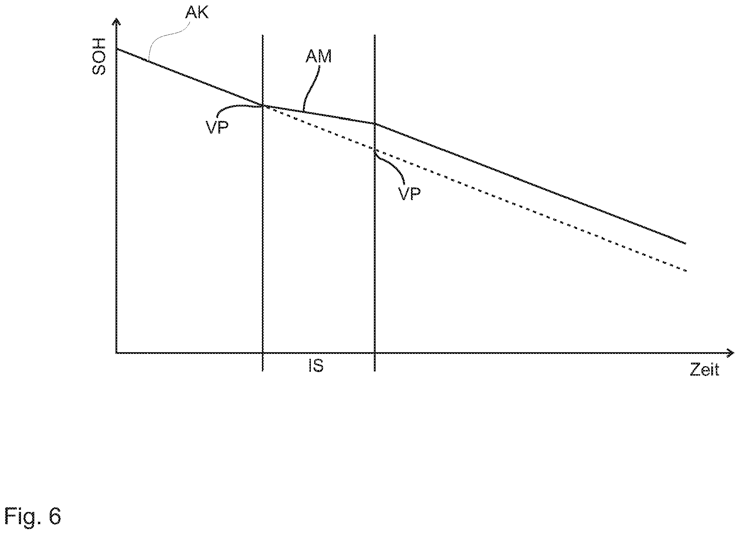

Die Wirkungsweise eines erfindungsgemäßen Schutzverfahrens geht insbesondere aus den Figuren 5 bis 7 gut hervor. Figur 5 zeigt schematisch hier in linearer Darstellung einen Alterungsverlauf einer Batterievorrichtung 100 in Form einer Alterungskurve AK. Über die Zeit der x-Achse ist in y-Richtung der State of Health SOH aufgetragen. Bei normaler Betriebsnutzung der Batterievorrichtung 100 sinkt nun der State of Health SOH im Rahmen der Alterungskurve AK ab. In der Realität wird dies in den seltensten Fällen eine lineare Korrelation, sondern üblicherweise eine nichtlineare Korrelation sein. Erfindungsgemäß wird nun eine Überwachung für die Reduktion dieser Alterungsgeschwindigkeit möglich. Für die Reduktion kann, wie bereits erläutert worden ist, ein Störstrom IS eingesetzt werden. Ein entsprechendes Beispiel ist in der Figur 6 dargestellt. In einem Zeitfenster wird nun ein Störstrom IS beaufschlagt, welcher durch seine physikalische und/oder chemische Schutzwirkung die Alterungsgeschwindigkeit an der jeweiligen Elektrode der Batterievorrichtung 100 bremst. Die Alterung findet zwar weiterhin statt, also auch während der Beaufschlagung mit dem Störstrom IS sinkt die Alterungskurve AK und damit der State of Health SOH ab, jedoch in verlangsamter Weise. Um nun die Qualität und/oder die Quantität des Erfolgs dieses Störstroms IS zu bestimmen und damit eine Kontrolle gewährleisten zu können, können verschiedene Vergleichsparameter VP eingesetzt werden. Insbesondere wird nach der Beaufschlagung mit dem Störstrom IS ein Vergleich entweder mit einem Vergleichsparameter VP vor der Beaufschlagung mit dem Störstrom IS oder aber mit einem Vergleich ohne Beaufschlagung mit dem Störstrom IS durchgeführt. Die entsprechenden Informationen können zum Beispiel durch Sensorvorrichtungen 120 und/oder Simulationsmodelle 110 zur Verfügung gestellt werden. In der Figur 6 ist darüber hinaus noch der Änderungsgradient AM dargestellt, welcher als Vergleichsparameter VP, aber auch als Batterieparameter EBP Verwendung finden kann.

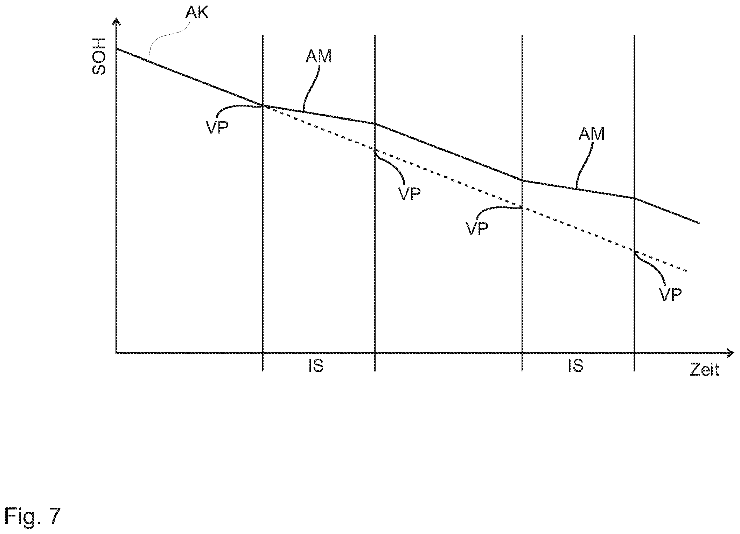

Neben der reinen Kontrolle, wie sie die Figur 6 zeigt, ist auch eine Rückkopplung für folgende Störströme IS möglich, wie sie die Figur 7 zeigt. So kann aus dem Erfolg des ersten Störstroms IS nun eine Rückkopplung für den zweiten Störstrom IS gezogen werden, welcher in verbesserter Weise zum Beispiel den Alterungsgradienten AM noch weiter bremst. Auch eine Rückkopplung in das Simulationsmodell 110 ist im Rahmen der vorliegenden Erfindung selbstverständlich denkbar.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichen

- 10: Kontrollvorrichtung
- 20: Überwachungsmodul
- 30: Vergleichsmodul

- 100: Batterievorrichtung
- 110: Simulationsmodel
- 120: Sensorvorrichtung
- 130: Sekundärbauteil

- EBP: Batterieparameter
- BP: Betriebsparameter
- IB: Betriebsstrom
- SP: Störparameter
- IS: Störstrom
- VP: Vergleichsparameter

- AK: Alterungskurve
- AM: Alterungsgradient
- SOH: State of Health

## Patentansprüche

1. Verfahren für eine Kontrolle eines Schutzverfahrens für den Schutz einer Batterievorrichtung (100), insbesondere einer Elektrode der Batterievorrichtung (100), aufweisend die folgenden Schritte:
- Überwachen wenigstens eines elektrischen Batterieparameters (EBP) der Batterievorrichtung (100),
- Überwachen wenigstens eines Betriebsparameters (BP) eines Betriebsstroms (IB) der Batterievorrichtung (100),
- Überwachen wenigstens eines Störparameters (SP) eines Störstroms (IS) der Batterievorrichtung (100),
- Vergleich des überwachten Störparameters (SP), des überwachten Betriebsparameters (BP) und/oder des überwachten Batterieparameters (EBP) mit wenigstens einem Vergleichsparameter (VP) auf Basis des Batterieparameters (EBP) und/oder des Betriebsparameters (BP),
**dadurch gekennzeichnet, dass** das Ergebnis des Vergleichs für eine, insbesondere nachfolgende, Erzeugung des Störparameters (SP) verwendet wird.

2. Verfahren nach Anspruch 1, **dadurch gekennzeichnet, dass** der Vergleich auf Basis eines Simulationsmodels (110) der Batterievorrichtung (100) durchgeführt wird, welches insbesondere wenigstens einen der folgenden Parameter berücksichtigt:
- Alterungszustand der Batterievorrichtung (100)
- Ladezustand der Batterievorrichtung (100)
- Temperatur der Batterievorrichtung (100)
- Qualität und/oder Quantität des Störparameters (SP)
- Qualität und/oder Quantität des Betriebsparameters (BP)
- Qualität und/oder Quantität des Batterieparameters (EBP)

3. Verfahren nach einem der Ansprüche 1 bis 2, **dadurch gekennzeichnet, dass** ein Vergleich eines Batterieparameters (EBP) und/oder eines Betriebsparameters (EBP) mit einem Vergleichsparameter (VP) durchgeführt wird, nachdem eine Beaufschlagung mit einem Störstrom (IS) beendet ist.

4. Verfahren nach Anspruch 3, **dadurch gekennzeichnet, dass** der Vergleichsparameter (VP) einen Batterieparameter (EBP) und/oder einen Betriebsparameter (BP) vor und/oder während der Beaufschlagung mit dem Störstrom (IS) aufweist.

5. Verfahren nach Anspruch 4, **dadurch gekennzeichnet, dass** das Ergebnis des Vergleichs für eine folgende Beaufschlagung mit einem Störstrom (IS) berücksichtigt wird.

6. Verfahren nach einem der Ansprüche 3 bis 5, **dadurch gekennzeichnet, dass** als Batterieparameter (EBP) ein Alterungszustand der Batterievorrichtung (BP) nach dem Störstrom (IS) mit einem Vergleichsparameter (VP) in Form eines Alterungszustands der Batterievorrichtung (100) vor dem Störstrom (IS) und/oder während des Störstroms (IS) eingesetzt wird.

7. Verfahren nach Anspruch 6, **dadurch gekennzeichnet, dass** beim Vergleich der Alterungszustände ein Alterungsgradient (AM) bestimmt wird.

8. Verfahren nach einem der Ansprüche 1 bis 7, **dadurch gekennzeichnet, dass** für den Vergleich ein Vergleichsparameter (VP) von wenigstens einer externen Batterievorrichtung (100) eingesetzt wird.

9. Verfahren nach einem der Ansprüche 1 bis 8, **dadurch gekennzeichnet, dass** als Vergleichsparameter (VP) ein Batterieparameter (EBP) und/oder ein Betriebsparameter (BP) ohne Beaufschlagung mit einem Störstrom (IS) verwendet wird.

10. Verfahren nach Anspruch 9, **dadurch gekennzeichnet, dass** für den Vergleichsparameter (VP) ein Simulationsmodell (110) der Batterievorrichtung (100) verwendet wird.

11. Kontrollvorrichtung (10) für die Kontrolle einer Batterievorrichtung (100), aufweisend ein Überwachungsmodul (20) für ein Überwachen wenigstens eines elektrischen Batterieparameters (EBP) einer Batterievorrichtung (100), ein Überwachen wenigstens eines Betriebsparameters (BP) eines Betriebsstroms (IB) der Batterievorrichtung (100) und ein Überwachen wenigstens eines Störparameters (SP) eines Störstroms (IS) der Batterievorrichtung (100), weiter aufweisend ein Vergleichsmodul (30) für einen Vergleich des überwachten Störparameters (SP), des überwachten Betriebsparameters (BP) und/oder des überwachten Batterieparameters (EBP) mit wenigstens einem Vergleichsparameter (VP) auf Basis des Batterieparameters (EBP) und/oder des Betriebsparameters (BP), wobei das Ergebnis des Vergleichs für eine, insbesondere nachfolgende, Erzeugung des Störparameters (SP) verwendet wird.

12. Kontrollvorrichtung (10) nach Anspruch 11, **dadurch gekennzeichnet, dass** das Überwachungsmodul (20) und/oder das Vergleichsmodul (30) für die Durchführung eines Verfahrens mit den Merkmalen eines der Ansprüche 1 bis 11 ausgebildet ist.

13. Computerprogrammprodukt, umfassend Befehle, die bei der Ausführung des Programms durch einen Computer diesen Veranlassen das Verfahren mit den Merkmalen eines der Ansprüche 1 bis 10 auszuführen.

## Claims

1. Method for checking a protection method for protecting a battery device (100), in particular an electrode of the battery device (100), comprising the following steps:
- monitoring at least one electrical battery parameter (EBP) of the battery device (100),
- monitoring at least one operating parameter (BP) of an operating current (IB) of the battery device (100),
- monitoring at least one interference parameter (SP) of an interference current (IS) of the battery device (100),
- comparing the monitored interference parameter (SP), the monitored operating parameter (BP) and/or the monitored battery parameter (EBP) with at least one comparison parameter (VP) based on the battery parameter (EBP) and/or the operating parameter (BP),
**characterised in that** the result of the comparison is used for, in particular subsequently, generating the interference parameter (SP).

2. Method according to claim 1, **characterised in that** the comparison is carried out based on a simulation model (110) of the battery device (100) that takes account, in particular, of at least one of the following parameters:
- state of ageing of the battery device (100)
- state of charge of the battery device (100)
- temperature of the battery device (100)
- quality and/or quantity of the interference parameter (SP)
- quality and/or quantity of the operating parameter (BP)
- quality and/or quantity of the battery parameter (EBP) .

3. Method according to any of claims 1 to 2, **characterised in that** a comparison of a battery parameter (EBP) and/or an operating parameter (EBP) with a comparison parameter (VP) is carried out after application of an interference current (IS) has ended.

4. Method according to claim 3, **characterised in that** the comparison parameter (VP) comprises a battery parameter (EBP) and/or an operating parameter (BP) before and/or during the application of the interference current (IS) .

5. Method according to claim 4, **characterised in that** the result of the comparison is taken into account for a subsequent application of an interference current (IS).

6. Method according to any of claims 3 to 5, **characterised in that** a state of ageing of the battery device (BP) after the interference current (IS) is used as the battery parameter (EBP) with a comparison parameter (VP) in the form of a state of ageing of the battery device (100) before the interference current (IS) and/or during the interference current (IS).

7. Method according to claim 6, **characterised in that** an ageing gradient (AM) is determined when comparing the states of ageing.

8. Method according to any of claims 1 to 7, **characterised in that** a comparison parameter (VP) of at least one external battery device (100) is used for the comparison.

9. Method according to any of claims 1 to 8, **characterised in that** a battery parameter (EBP) and/or an operating parameter (BP) is used as the comparison parameter (VP) without application of an interference current (IS).

10. Method according to claim 9, **characterised in that** a simulation model (110) of the battery device (100) is used for the comparison parameter (VP).

11. Checking device (10) for checking a battery device (100), comprising a monitoring module (20) for monitoring at least one electrical battery parameter (EBP) of a battery device (100), monitoring at least one operating parameter (BP) of an operating current (IB) of the battery device (100) and monitoring at least one interference parameter (SP) of an interference current (IS) of the battery device (100), further comprising a comparison module (30) for comparing the monitored interference parameter (SP), the monitored operating parameter (BP) and/or the monitored battery parameter (EBP) with at least one comparison parameter (VP) based on the battery parameter (EBP) and/or the operating parameter (BP), wherein the result of the comparison is used for, in particular subsequently, generating the interference parameter (SP).

12. Checking device (10) according to claim 11, **characterised in that** the monitoring module (20) and/or the comparison module (30) is designed to carry out a method having the features of any of claims 1 to 11.

13. Computer program product, comprising commands which, when the program is executed by a computer, prompt same to execute the method having the features of any of claims 1 to 10.

## Revendications

1. Procédé pour contrôler un procédé de protection pour protéger un ensemble batterie (100), en particulier une électrode de l'ensemble batterie (100), comprenant les étapes suivantes :
- Surveillance d'au moins un paramètre de batterie électrique (EBP) de l'ensemble batterie (100),
- Surveillance d'au moins un paramètre de performance (BP) d'un courant de pilotage (IB) de l'ensemble batterie (100),
- Surveillance d'au moins un paramètre de perturbation (SP) d'un courant perturbateur (IS) de l'ensemble batterie (100),
- Comparaison du paramètre de perturbation (SP) surveillé, du paramètre de performance (BP) surveillé et/ou du paramètre de batterie (EBP) surveillé avec au moins un paramètre de comparaison (VP) sur la base du paramètre de batterie (EPB) et/ou du paramètre de performance (BP),
**caractérisé en ce que** le résultat de la comparaison est utilisé pour générer, notamment ultérieurement, le paramètre de perturbation (SP).

2. Procédé selon la revendication 1, **caractérisé en ce que** la comparaison est effectuée sur la base d'un modèle de simulation (110) de l'ensemble batterie (100), lequel prend notamment en compte au moins l'un des paramètres suivants :
- État de vieillissement de l'ensemble batterie (100)
- État de charge de l'ensemble batterie (100)
- Température de l'ensemble batterie (100)
- Qualité et/ou quantité du paramètre de perturbation (SP)
- Qualité et/ou quantité du paramètre de performance (BP)
- Qualité et/ou quantité du paramètre de batterie (EBP)

3. Procédé selon l'une des revendications 1 à 2, **caractérisé en ce qu'**une comparaison d'un paramètre de batterie (EBP) et/ou d'un paramètre de performance (EBP) est effectuée avec un paramètre de comparaison (VP) après qu'une exposition à un courant perturbateur (IS) ait pris fin.

4. Procédé selon la revendication 3, **caractérisé en ce que** le paramètre de comparaison (VP) comprend un paramètre de batterie (EBP) et/ou un paramètre de performance (BP) avant et/ou pendant l'exposition au courant perturbateur (IS).

5. Procédé selon la revendication 4, **caractérisé en ce que** le résultat de la comparaison est pris en compte pour une exposition suivante à un courant perturbateur (IS).

6. Procédé selon l'une des revendications 3 à 5, **caractérisé en ce qu'**on utilise comme paramètre de batterie (EBP) un état de vieillissement de l'ensemble batterie (BP) après le courant perturbateur (IS) avec un paramètre de comparaison (VP) sous la forme d'un état de vieillissement de l'ensemble batterie (100) avant le courant perturbateur (IS) et/ou pendant le courant perturbateur (IS).

7. Procédé selon la revendication 6, **caractérisé en ce qu'**un gradient de vieillissement (AM) est déterminé lors de la comparaison des états de vieillissement.

8. Procédé selon l'une des revendications 1 à 7, **caractérisé en ce qu'**un paramètre de comparaison (VP) d'au moins un ensemble batterie externe (100) est utilisé pour la comparaison.

9. Procédé selon l'une des revendications 1 à 8, **caractérisé en ce qu'**on utilise comme paramètre de comparaison (VP), un paramètre de batterie (EBP) et/ou un paramètre de performance (BP) sans exposition à un courant perturbateur (IS).

10. Procédé selon la revendication 9, **caractérisé en ce qu'**un modèle de simulation (110) de l'ensemble batterie (100) est utilisé pour le paramètre de comparaison (VP).

11. Ensemble de contrôle (10) pour contrôler un ensemble batterie (100), présentant un module de surveillance (20) pour une surveillance d'au moins un paramètre de batterie électrique (EBP) d'un ensemble batterie (100), une surveillance d'au moins un paramètre de performance (BP) d'un courant de pilotage (IB) de l'ensemble batterie (100), et une surveillance d'au moins un paramètre de perturbation (SP) d'un courant perturbateur (IS) de l'ensemble batterie (100), présentant en outre un module de comparaison (30) pour une comparaison du paramètre de perturbation (SP) surveillé, du paramètre de performance (BP) surveillé et/ou du paramètre de batterie (EBP) surveillé avec au moins un paramètre de comparaison (VP) sur la base du paramètre de batterie (EBP) et/ou du paramètre de performance (BP), le résultat de la comparaison étant utilisé pour une génération, notamment ultérieure, du paramètre de perturbation (SP).

12. Ensemble de contrôle (10) selon la revendication 11, **caractérisé en ce que** le module de surveillance (20) et/ou le module de comparaison (30) est conçu pour la mise en oeuvre d'un procédé présentant les caractéristiques de l'une des revendications 1 à 11.

13. Produit programme d'ordinateur comprenant des instructions qui, lors de l'exécution du programme par un ordinateur, amènent celui-ci à exécuter le procédé ayant les caractéristiques de l'une quelconque des revendications 1 à 10.
